# EUROPÄISCHE PATENTSCHRIFT

(11) **EP 3 142 043 B1**
(45) Veröffentlichungstag und Bekanntmachung des Hinweises auf die Patenterteilung: **22.03.2023**
(21) Anmeldenummer: 16182838.9
(22) Anmeldetag: 04.08.2016
(51) Int. Cl.: G06V 40/13, G06V 40/60

(54) **VORRICHTUNG UND VERFAHREN ZUR OPTISCHEN AUFNAHME VON ABDRÜCKEN VON DURCHBLUTETEN HAUTBEREICHEN**
DEVICE AND METHOD FOR OPTICAL RECORDING OF AREAS OF SKIN WITH BLOOD FLOWING THROUGH
DISPOSITIF ET PROCEDE DE RECEPTION OPTIQUE D'EMPREINTES DE ZONES DE PEAU IRRIGUEES

(30) Priorität: 11.09.2015 DE 102015115381
(43) Veröffentlichungstag der Anmeldung: 15.03.2017
(73) Patentinhaber: Jenetric GmbH, 07749 Jena (DE)
(72) Erfinder: Reinhold, Jörg, 07743 Jena (DE); Wolfer, Roberto, 07749 Jena (DE); Morgeneier, Dirk, 07749 Jena (DE)
(74) Vertreter: Gleim Petri Oehmke Patent- und Rechtsanwaltspartnerschaft mbB

(56) Entgegenhaltungen:
- EP-A2- 2 711 869
- WO-A1-2012/158950
- CN-U- 204 028 936
- US-A- 5 446 290
- US-A1- 2005 213 173
- US-A1- 2013 120 760
- US-A1- 2014 036 168

## Beschreibung

### Gebiet der Erfindung

Die Erfindung betrifft eine Vorrichtung und ein Verfahren zur optischen Aufnahme von Abdrücken von durchbluteten Hautbereichen menschlicher Autopodien oder Teilen davon. Eine solche Vorrichtung umfasst aus der Richtung eines aufzulegenden Hautbereichs, beispielsweise aus Richtung einer Person, die einen Finger oder eine Hand auf einen Fingerabdrucksensor auflegen soll, eine Auflagefläche zur Auflage mindestens eines Hautbereichs. Die Vorrichtung umfasst außerdem einen Schichtkörper mit einer Sensorschicht, in der in einem ersten Pixelraster lichtempfindlichen Sensorelemente mit vorgegebenen lateralen Abmessungen angeordnet sind Die Vorrichtung umfasst außerdem mehrere lichtabstrahlende Elemente.

### Stand der Technik

Die Identifizierung und Erfassung von Personen über biometrische Merkmale gewinnt immer mehr an Bedeutung. Dabei spielt der Finger- und / oder Handabdruck neben anderen erfassbaren biometrischen Merkmalen eine wichtige Rolle. Es gibt einerseits Systeme, die der Verifikation biometrischer Merkmale dienen, bei denen also eine Übereinstimmung mit abgespeicherten Merkmalen vorliegen muss, beispielsweise um eine Zugangs- oder Zugriffskontrolle zu ermöglichen. Andere Systeme dienen der Identifikation durch Suchen und Speichern in Vergleichsdatenbanken, beispielsweise bei Grenzkontrollen an Flughäfen oder bei der erkennungsdienstlichen Erfassung durch die Polizei. Für die letztgenannten Systeme gibt es eine Vielzahl von Forderungen hinsichtlich der Qualität, der Auflösung und der Originaltreue der aufgenommenen Bilder von den Hauttexturen. Nicht zuletzt aufgrund hoher Anforderungen durch mit erkennungsdienstlichen Maßnahmen betrauten Organisationen wie beispielsweise des *Federal Bureau of Investigation* (FBI) gibt es bei diesen Systemen ein hohes Maß der Standardisierung, um einerseits eine möglichst zweifelsfreie Erkennung zu sichern und andererseits Datensätze, die mit verschiedenen Systemen aufgenommen wurden, vergleichbar zu machen. Beispielsweise müssen solche Systeme eine Auflösung von mindestens 500 ppi haben, was einem Pixelabstand von 50,8 µm entspricht. Außerdem werden bestimmte Anforderungen an die Kontrasttransferfunktion *(Contrast Transfer Function, CTF),* das Signal-Rausch-Verhältnis *(Signal Noise Ratio, SNR)* und an die Verzeichnung gestellt. Schließlich muss die Farbskala mindestens 200 Grauwerte umfassen und das Bildfeld muss sowohl in der näheren Pixelumgebung als auch im gesamten Bild möglichst homogen ausgeleuchtet sein.

Alle Anforderungskriterien benötigen ein ausgewogenes und qualitativ hochwertiges Systemdesign. Bei einem optischen System bedeutet das beispielsweise, dass nicht nur der Aufnahmesensor bzw. die Aufnahmesensoren den Anforderungen genügen müssen, sondern auch die Beleuchtung und alle anderen für die Bilderzeugung notwendigen Komponenten.

Für die Erfassung von Finger- und Handabdrücken, welche die genannten hohen Qualitätsanforderungen erfüllen, werden derzeit überwiegend optische Anordnungen verwendet, die nach dem Prinzip der gestörten Totalreflexion arbeiten. Dabei wird ein Prisma angesetzt, dessen für die Aufnahme des Abdrucks vorgesehene Fläche aufgrund mechanischer und optischer Anforderungen größer als die geforderte Fläche für die Aufnahme des Abdrucks sein muss. Die daraus resultierende Größe des Prismas als häufig größeres Bauteil im Aufnahmekanal beeinflusst die Mindestbaugröße und die Mindestmasse eines Gerätes entscheidend. Die hohe Bildgüte erlaubt demgegenüber jedoch eine schnelle und sichere Erfassung und Identifizierung der Personen, insbesondere auch bei Anwendungen, wo neben forensischer Genauigkeit auch ein hoher Personendurchsatz, wie beispielsweise bei Grenzkontrollen, eine Rolle spielt. Neben der bereits genannten Baugröße und der Masse bestehen weitere Nachteile in der notwendigen Verwendung komplexer mechanischer Bauteile sowie in einer technisch und zeitlich aufwendigen Montage und Justierung. Die Nutzerführung bei solchen Geräten erfolgt über Informationen, die außerhalb der Auflagefläche präsentiert werden, wie z.B. durch einen nebengelagerten Bildschirm. Dadurch muss bei der Aufnahme von Hautabdrücken die Person den Blick immer wieder zwischen der Auflagefläche und dem Bildschirm wechseln.

Miniaturisierte Anordnungen mit abbildender Optik, wie sie beispielsweise in der US 7,379,570 B2 beschrieben sind, genügen im Allgemeinen nicht den hohen Standards, welcher beispielsweise vom FBI vorgegeben wird und begrenzen aufgrund des optischen Strahlengangs immer noch eine weitergehende Miniaturisierung der Geräte. Ultraschall- oder piezoelektrische Sensoren, wie sie beispielsweise aus der US 4,394,773 bekannt sind, sowie kapazitive Sensoren, wie sie beispielsweise in der US 5,325,442 beschrieben sind, können Fingerabdrücke nicht-optisch aufnehmen. Geräte auf Basis von Ultraschall-Sensoren befinden sich noch nicht auf dem Markt. Kapazitive Sensoren wiederum existieren bisher nur für Ein- oder Zweifingeraufnahmen. Alle nicht-optische Prinzipien haben bisher den Nachteil, dass sich keine Informationen direkt auf dem Sensor anzeigen lassen. Folientastaturen, wie sie beispielsweise in der US 2005/0229380 A1 beschrieben sind, erfüllen die notwendigen Kriterien nicht.

Um den Vorteil der hohen Bildgüte, die mit gestörter Totalreflexion erreicht werden kann, mit geringer Baugröße zu verbinden, wurden bereits in der US 2012/0321149 A1 Ansätze beschrieben. Der dort offenbarte Fingerabdrucksensor, bei welchem der Finger auf ein TFT-Display gelegt wird, nimmt einen Fingerabdruck auf und überträgt diesen über eine Elektronik zu einem Computersystem. Das dem Fingerabdruck entsprechende Helligkeitsprofil entsteht dabei - wie bei Anordnungen mit Prismen - dadurch, dass die auf der Oberfläche des TFT-Displays aufliegenden Hautleisten die interne Reflexion des Lichtes von der Lichtquelle stören, während in den Papillarkörperleisten, also den Hauttälern, kein Kontakt zwischen Haut und TFT-Oberfläche auftritt und dort das Licht von der Lichtquelle an der Oberfläche des TFT intern reflektiert wird. Auf den lichtempfindlichen Bereichen des TFT entsteht somit ein Negativbild des Fingerabdruckbildes. Diese Lösung setzt jedoch voraus, dass das obere Substrat eine Mindestdicke hat, damit das Licht auf die lichtempfindlichen Bereiche des TFT treffen kann. Außerdem ist es notwendig, dass die Beleuchtung bestimmte Anforderungen bezüglich Einfallsrichtung und Öffnungswinkel erfüllt, was den technischen Aufwand für die Beleuchtung und auch deren Platzbedarf deutlich vergrößert. Die in der US 2012/0321149 A1 beschriebenen Ausführungen für Beleuchtungen sind für große Aufnahmeflächen für mehr als einen oder zwei Finger nicht oder nur bedingt, da mit großen Aufwand verbunden, geeignet.

Ein weiteres Konzept für eine flache Bauweise ohne abbildende Optik wird in der US 7,366,331 B2 beschrieben. Hier wird das Licht seitlich mittels einer flächigen Beleuchtung in den Finger gekoppelt und in die aufliegende Hautpartie gestreut. Der Finger befindet sich in Kontakt zu einer transparenten Schicht zwischen Finger und Sensor. Somit koppelt vorzugsweise Licht aus den Hautbergen in diese Schicht und kann dann von dem flächenförmigen Sensor detektiert werden. Dieses Konzept bedingt Beleuchtungswellenlängen innerhalb des Transparenzbereichs des Fingers, d.h. insbesondere im nahen und mittleren Infrarotbereich, und bringt daher erhebliche Umgebungslichtprobleme mit sich. Die vorgeschlagene Verwendung von Infrarotfiltern und Infrarotbeleuchtung reduziert diese Probleme zwar, jedoch besteht dann eine geringere Empfindlichkeit üblicher Sensoren und die Absorption des Fingers ist höher, was das Signal-Rausch-Verhältnis verschlechtert. Gegebenenfalls verwendete schmalbandige Spektralfilter müssen entsprechend der Wellenlänge der Beleuchtung angepasst werden und erzeugen zusätzlichen technischen Aufwand. Die seitliche Beleuchtung verursacht Probleme bei der Homogenität der Ausleuchtung, insbesondere verhindert sie die gleichzeitige Aufnahme mehrerer Finger, da sich diese gegenseitig abschatten würden. Dieses Konzept ist also nur für die Aufnahme eines Fingers geeignet. Außerdem ist ein Lichtschild notwendig, um zu verhindern, dass Anteile der Beleuchtung direkt in den Sensor gelangen. Die seitliche Beleuchtung und der Lichtschild vergrößern das Gerät und es wird aufwendiger, unflexibler und fehleranfälliger.

In der EP 2 711 869 A2 werden eine Anordnung und ein Verfahren zur Aufnahme von Fingerabdrücken beschrieben. Der Benutzer, der einen Finger oder eine Hand auf eine Aufnahmefläche auflegt, erhält auf einer zwar in der Nähe, jedoch von der Aufnahmefläche räumlich getrennten Anzeigeeinheit, Informationen mittels Piktogrammen, Bildern oder Ähnlichem. Diese Informationen geben beispielsweise Aufschluss darüber, ob beispielsweise die Auflageposition und/oder der Anpressdruck akzeptabel sind oder beispielsweise ob alle Finger aufliegen oder einige Finger fehlen, wenn die ganze Hand aufgenommen werden soll. Aufgrund der räumlichen Trennung von Aufnahmefläche und Anzeige ist es für die Person, deren Abdrücke registriert werden sollen, umständlich die Position der Autopodien auf der Aufnahmefläche zu korrigieren, da die Übertragung des auf der Anzeigefläche dargestellten Bildes auf das Verhalten beziehungsweise eine geforderte Bewegung beispielsweise einzelner Finger nicht sofort und intuitiv erfolgt. Des Weiteren besteht aufgrund der räumlichen Trennung von Aufnahmefläche und Anzeigeeinheit das Risiko, dass der Nutzer die Finger nicht auf der Auflagefläche sondern auf die Anzeige platziert. Das ist insbesondere dann gegeben, wenn die Darstellung auf der Anzeige die aufzunehmenden Finger anzeigt. Die Aufnahme von gerollten Fingern bedarf besonders hohe Aufmerksamkeit während des Aufnahmevorgangs, da nur mit kontinuierlicher Geschwindigkeit und kontinuierlichem Druck eine zufriedenstellende Fingerabdruckaufnahme möglich ist. Das wird üblicherweise dadurch erreicht, dass der Aufnahmevorgang auf einer Anzeige in Echtzeit dargestellt wird. Bei räumlicher Trennung von Aufnahmefläche und Anzeige ist es für den Benutzer sehr schwierig, den Aufnahmevorgang und die Anzeige zu synchronisieren. In der Praxis führt das zu oft zu fehlerhaften Fingerabdruckaufnahmen welche wiederholt werden müssen.

Weitere relevante Dokumente aus dem Stand der Technik sind: WO 2012/158950, US5446290, CN204028936 und US2014/036168.

### Beschreibung der Erfindung

Aufgabe der Erfindung ist es daher, eine Anordnung der eingangs beschriebenen Art und ein Verfahren zur Aufnahme von Abdrücken von Autopodien dahingehend weiterzuentwickeln, das es einer Person, deren Fingerabdrücke beispielsweise aufgenommen werden sollen, leichter fällt, zu erkennen, wie die Auflage der Finger korrigiert werden muss, um ein zufriedenstellendes Ergebnis für einen Abdruck zu erhalten. Der Person soll ein ortsnäheres, intuitiveres Feedback gegeben werden, als mit dem Stand der Technik möglich, so dass auf diese Weise auch die Verweilzeit am Aufnahmegerät verkürzt werden kann und fehlerhafte Aufnahmen reduziert werden.

Diese Aufgabe wird bei einer Vorrichtung der eingangs beschriebenen Art dadurch gelöst, dass nebeneinander mehrere lichtabstrahlende Elemente angeordnet sind. Die lichtabstrahlenden Elemente sind dabei (i) rasterförmig in einem zweiten Pixelraster angeordnet, (ii) Licht in einem Frequenzbereich abstrahlend ausgebildet, für welchen der Schichtkörper zumindest teilweise durchlässig ist, so dass das Licht durch du Auflagefläche hindurch in Richtung eines Hautbereichs in diesen einkoppelbar ist, und (iii) einzeln oder gruppenweise ansteuer- und damit ein- und ausschaltbar. Dabei beträgt der Abstand eines jeden lichtempfindlichen Sensorelements zur Auflagefläche weniger als der Pixelpitch des ersten Pixelrasters, bevorzugt weniger als die Hälfte dieses Pixelpitches. Durch die letztegenannte Maßnahme kann effektiv verhindert werden, dass sich Informationen verschiedener Objekte in einem Pixel überlagern, d.h. es erfolgt keine Überblendung verschiedener Objektinformationen.

Da die lichtabstrahlenden Elemente rasterförmig in einem zweiten Pixelraster angeordnet und einzeln ansteuerbar sind, ist es möglich, in der direkten Umgebung des aufgelegten Fingers, abhängig von den registrieren Intensitätswerten entsprechende visuelle Informationen darzustellen, die die Person, deren Fingerabdrücke beispielsweise genommen werden sollen, beim Blick auf seine Finger unmittelbar erfasst und entsprechend reagieren kann, sofern dies notwendig sein sollte. Beispiele für solche visuellen Informationen werden bei der Beschreibung des erfindungsgemäßen Verfahrens, das insbesondere die erfindungsgemäße Anordnung benutzen kann, gegeben.

In Ergänzung zu der Darstellung visueller Informationen ist es auch möglich, bei entsprechender Ausgestaltung der Vorrichtung akustische Signale oder haptische Signale - beispielsweise in Teilbereichen der Auflagefläche - zu emittieren, so dass ein Benutzer darauf reagieren kann. Haptische oder taktile Signale eignen sich besonders gut für Menschen mit eingeschränkter Sehfähigkeit.

In einer bevorzugten Ausgestaltung ist zwischen Auflagefläche und dem Schichtkörper ein als Hochpass ausgebildeter Spektralfilter angeordnet. Dessen Grenzwellenlänge ist in Abhängigkeit von dem optischen Absorptionsverhalten der durchbluteten Hautbereiche vorgegeben, unterhalb der Grenzwellenlänge ist der Spektralfilter zumindest im sichtbaren optischen Bereich im Wesentlichen durchlässig. Außerdem ist der Spektralfilter für das von den lichtabstrahlenden Elementen abgestrahlte Licht zumindest teilweise durchlässig.

Für die Anordnung der lichtabstrahlenden Elemente gibt es verschiedene Möglichkeiten. Beispielsweise können die lichtabstrahlenden Elemente außerhalb des Schichtkörpers oder in einer gesonderten Beleuchtungsschicht im Schichtkörper angeordnet sein, wobei die Beleuchtungsschicht dann unterhalb der Sensorschicht, also auf der dem Spektralfilter abgewandten Seite, angeordnet ist. Die lichtabstrahlenden Elemente können aktiv oder passiv lichtabstrahlend ausgebildet sein, bei der Anordnung in einer gesonderten Beleuchtungsschicht ist es besonders vorteilhaft, die Beleuchtungsschicht als ein LC-Display - also mit passiv lichtabstrahlenden Elementen - und mit einer Hintergrundbeleuchtung auszugestalten. Solche Elemente sind leicht herzustellen und anzusteuern, wobei hier die Transmissivität der einzelnen Pixel des LC-Displays gesteuert wird.

In einer anderen Ausgestaltung können die lichtabstrahlenden Elemente auch durch mobile Kommunikationsgeräte - beispielsweise Tablets oder Smartphones - ausgebildet sein. Hierbei dient das mobile Gerät als Beleuchtungsschicht, welche unterhalb der Sensorschicht angeordnet ist. Auf diese Weise lässt sich eine besonders kompakte Bauform für den mobilen Einsatz sowie eine einfache Realisierung von visuellen oder haptischen Informationen über das mobile Gerät erreichen.

Auf die Hintergrundbeleuchtung kann verzichtet werden, wenn die lichtabstrahlenden Elemente aktiv Licht abstrahlend ausgebildet sind, beispielsweise als LED oder OLED. Die Dicke der Vorrichtung und der Herstellungsaufwand kann auf diese Weise reduziert werden. Eine weitere Reduzierung der Dicke und des Herstellungsaufwandes ist möglich, wenn die lichtabstrahlenden Elemente in die Schicht mit den lichtempfindlichen Sensorelementen, d.h. die Sensorschicht selbst integriert sind. Die lichtempfindlichen Sensorelemente und die lichtabstrahlenden Elemente liegen dann in einer Ebene. Auch hier sind die lichtabstrahlenden Elemente bevorzugt als aktiv lichtabstrahlende Elemente, beispielsweise als LED oder als OLED ausgebildet.

Die Pixelraster müssen nicht notwendigerweise die gleichen Abmessungen haben, da an die Engmaschigkeit bzw. Auflösung des zweiten Pixelrasters mit den lichtabstrahlenden Elementen keine so hohen Anforderungen wie an das erste Pixelraster der lichtempfindlichen Sensorelemente gestellt werden. Je feiner das zweite Pixelraster ist, desto höher ist jedoch die Auflösung und desto genauer lassen sich die visuellen Informationen darstellen. Bevorzugt liegen das erste und das zweite Pixelraster in einer Ebene und haben identische Pixelpitches. Die lichtabstrahlenden Elemente sind dann in den Mittelpunkten der Pixel des ersten Pixelrasters und die lichtempfindlichen Sensorelemente in den Mittelpunkten des zweiten Pixelrasters angeordnet. Auf diese Weise lässt sich eine besonders dünne Bauweise realisieren, aufgrund der entsprechenden Pixelgröße ist die Darstellung darüber hinaus besonderes genau.

Die Grenzwellenlänge des optionalen Spektralfilters wird bevorzugt in Abhängigkeit vom optischen Absorptionsverhalten der durchbluteten Hautbereiche vorgegeben. Verantwortlich für das Absorptionsverhalten ist überwiegend das Hämoglobin im Blut, welches oberhalb einer Wellenlänge von etwa 600 nm im Wesentlichen lichtdurchlässig ist, für Wellenlängen darunter, insbesondere im grünen und blauen Wellenlängenbereich andererseits stark absorbiert. Die Grenzwellenlänge des Spektralfilters liegt daher bevorzugt in einem Bereich von 600 ± 50 nm oder 575 ± 25 nm, beispielsweise bei 575 oder 600 nm. Der Spektralfilter ist dann im Wesentlichen nur für blaues und grünes Licht durchlässig. Da der Finger jedoch für blaues und grünes Licht undurchlässig ist, macht sich störendes Umgebungslicht allenfalls an den Rändern des Fingers bemerkbar. Dies ermöglicht eine genauere Bestimmung, ob die aufzunehmenden Autopodien an den richtigen Positionen liegen, oder ob der richtige Anpressdruck, der für eine optimale Kontrastbildung zwischen Hautbergen und Hauttälern notwendig ist, gegeben ist.

Die Erfindung betrifft außerdem ein Verfahren zur Aufnahme von Abdrücken von durchbluteten Hautbereichen menschlicher Autopodien oder Teilen davon, welches sich insbesondere mit der vorangehend beschriebenen Vorrichtung durchführen lässt. Bei einem solchen Verfahren wird mindestens ein Hautbereich, dessen Abdruck genommen werden soll, einer Auflagefläche einer Vorrichtung zur Aufnahme solcher Abdrücke genähert und auf diese aufgelegt. Mehrere, rasterförmig in einem zweiten Pixelraster angeordnete, einzeln oder gruppenweise ansteuerbare, lichtabstrahlende Elemente werden zur Beleuchtung des mindestens einen Hautbereichs an- oder abgeschaltet. Bei passiven lichtabstrahlenden Elementen entspricht das Anschalten dem Schalten auf lichtdurchlässig. Das von den lichtabstrahlenden Elementen abgestrahlte Licht tritt dabei durch einen Schichtkörper mit in einem ersten Pixelraster angeordneten, lichtempfindlichen Sensorelementen vorgegebener lateraler Abmessungen, durch einen optionalen Spektralfilter sowie durch die Auflagefläche hindurch auf und in mindestens einen Hautbereich. Dort wird das Licht je nach Beschaffenheit und Lage des Hautbereichs, in Abhängigkeit ob es sich beispielsweise um einen Hautberg oder ein Hauttal handelt, umgelenkt und gegebenenfalls wieder in Richtung der Auflagefläche ausgekoppelt. Das ausgekoppelte Licht tritt wieder durch die Auflagefläche hindurch und wird auf die lichtempfindlichen Sensorelemente gelenkt. Dort wird die Intensität des Lichts registriert, wobei der Abstand eines jeden lichtempfindlichen Sensorelements zur Auflagefläche weniger als der Pixelpitch des ersten Pixelrasters beträgt, bevorzugt weniger als die Hälfte des Pixelpitches. Die durch die lichtempfindlichen Sensorelemente registrierten bzw. bestimmten Intensitätswerte werden dann einer Bildverarbeitung zugeführt, welche in die Vorrichtung integriert sein kann. Über an sich bekannte Bildverarbeitungsalgorithmen erhält man als Ergebnis verschiedene Parameter, die die Qualität und Korrektheit der Aufnahme bewerten, insbesondere erhält man als Ergebnis mindestens Aussagen über die Position, die Form und / oder ob der Anpressdruck des mindestens einen Hautbereichs korrekt, zu hoch oder zu niedrig war, was in der Regel am Kontrast erkennbar ist. In Abhängigkeit von dem bestimmten Ergebnis werden dann die lichtabstrahlenden Elemente angesteuert und an- oder ausgeschaltet. Dabei werden von den lichtabstrahlenden Elementen visuelle Informationen dargestellt, welche auf der Auflagefläche angezeigt werden, so dass sie ein Betrachter - in der Regel die Person, deren Hand oder Finger aufliegt - unmittelbar in der Nähe der betroffenen Hautbereiche sieht.

Liegen beispielsweise mehrere Finger korrekt auf und war auch der Anpressdruck korrekt, so kann dies beispielsweise mit einer grünen Kontur, die direkt um den Finger gezeigt wird, angedeutet werden. Ein falsch positionierter Finger kann beispielsweise mittels einer roten Kontur umgeben werden, zusätzlich kann mit Pfeilsymbolen angedeutet werden, in welche Richtung der Finger zu bewegen ist, oder beispielsweise mit einem Gewichtssymbol und einem nach unten bzw. nach oben zeigenden Pfeil, ob der Anpressdruck erhöht oder erniedrigt werden muss. Bei entsprechender Ausgestaltung der zur Durchführung des Verfahrens verwendeten Vorrichtung kann auch eine akustische und / oder taktile / haptische Rückkopplung an die Person, deren Hautbereiche registriert werden sollen, gegeben werden. Beispielsweise kann für einen falsch aufgelegten Finger die korrekte Position durch eine lokal begrenzte Vibration des entsprechenden Bereichs - dies lässt sich beispielsweise mit Hilfe piezoelektrischer Elemente erreichen - angedeutet werden. Der Benutzer ist dann aufgefordert, seinen Finger so zu verschieben, dass der gesamte Bereich, der aufgenommen werden soll, auf der vibrierenden, lokal begrenzten Fläche aufliegt. Sobald die korrekte Position erreicht ist, wird die Vibration angehalten. Es wird also insbesondere in Abhängigkeit von dem bestimmten Ergebnis angezeigt oder spürbar gemacht, ob eine Veränderung der Position und / oder des Anpressdrucks des Hautbereichs erforderlich ist.

Dem Benutzer kann auch, bevor er den Hautbereich in Kontakt mit der Auflagefläche gebracht hat, die Silhouette der Autopodien angezeigt werden, so dass er genau weiß, wo und wie diese aufgelegt werden sollen. Legt er diese nicht an die korrekte Position oder nicht mit dem korrekten Anpressdruck - jeweils innerhalb vorgegebener Toleranzen - auf die Auflagefläche, so werden dem Benutzer bevorzugt ebenfalls auf der Auflagefläche Informationen angezeigt oder mitgeteilt, in welcher Weise eine Korrektur zu erfolgen hat. Hat der Benutzer die Korrekturen erfolgreich durchgeführt, kann das für den Benutzer wahrnehmbar aktiv und positiv quittiert werden.

In einer weiteren bevorzugten Ausgestaltung werden die lichtempfindlichen Elemente so angesteuert, dass sie bereits während der Annäherung des aufzunehmenden Hautbereichs Signale aufnehmen, beispielsweise den Schattenwurf oder die Kontur einer Hand. Diese Signale werden durch einen Bildverarbeitungsalgorithmus analysiert, so dass festgestellt werden kann, ob es sich tatsächlich um ein aufzunehmendes Objekt handelt. In dem Fall, dass die Annäherung eines zu registrierenden Hautbereichs verifiziert wird, werden weitere Schritte initialisiert. Beispielsweise kann die Beleuchtung der Vorrichtung - die Auflagefläche dient gleichzeitig als Bildschirm - aktiviert werden und es kann einer Person beispielsweise eine Position dargestellt werden, auf die sie ihre Hand zu legen hat. Dies kann beispielsweise mit einer mit Weißlicht dargestellten Kontur einer Hand, deren einzelne Finger unterschieden werden, erfolgen. Nach oder während der Messung der Intensitätswerte durch die lichtempfindlichen Sensoren kann dann von weißem Licht für die Kontur auf grünes oder rotes Licht umgeschaltet werden, in Abhängigkeit von den registrierten Messwerten.

In einer bevorzugten Ausgestaltung dieses Verfahrens werden bei der Annäherung des Hautbereichs aufgenommene Signale mit bei aufgelegtem Hautbereich aufgenommenen Signalen verglichen. Die Farbe eines Hautbereichs ändert sich wenn er Druck ausgesetzt wird, in diesem Fall, wenn der Hautbereich auf die Auflagefläche gedrückt wird. Dieser Effekt wird ausgenutzt, um Fälschungen zu erkennen. Durch definierte Beleuchtungsfarben lassen sich spektrale Informationen über den Sensor aufnehmen. Wird registriert, dass sich ein Hautbereich nähert, so wird von einem Ruhe- in einen Annäherungszustand geschaltet. In diesem wird bereits ein erstes Bild, bei einer bestimmten Beleuchtungsfarbe, aufgenommen, d.h. es werden erste spektrale Signale registriert. Aufnahmen mit weiteren Beleuchtungsfarben folgen optional. Liegt der Hautbereich auf, wird vom Annäherungszustand in einen Aufnahmezustand geschaltet, und es wird - nach korrekter Positionierung und bei korrekter Druckausübung - ein weiteres Bild, oder optional mehrere weitere Bilder bei unterschiedlichen Beleuchtungsfarben, aufgenommen. Spektrale Signaturen des Hautbereichs vor und nach dem Kontakt mit der Auflagefläche werden generiert. Der Unterschied beider Signaturen ist spezifisch für lebende Haut. Fälschungen lassen sich somit erkennen. Ist der Unterschied beider spektraler Signaturen nicht innerhalb eines vorgegebenen Intervalls, so wird der Aufnahmevorgang als Täuschungsversuch abgebrochen.

Gleichermaßen ist es in einer alternativen Ausgestaltung des Verfahrens, die ohne weiteres mit dem vorab beschriebenen kombiniert werden kann, möglich, die Vorrichtung so einzustellen, dass in Abhängigkeit von der auf der Auflagefläche bestimmten Position Programmbefehle ausgeführt werden, beispielsweise Programme gestartet, Programme beendet oder in Programmen bestimmte Einstellungen vorgenommen werden. In diesem Fall kann die Vorrichtung nicht nur als Gerät zur Aufnahme von Fingerabdrücken verwendet werden, sondern auch als berührungsempfindliches Panel, beispielsweise als Touchpad oder Smartphone. Anders ausgedrückt, ist die Funktionalität der Fingerabdruckregistrierung ohne Weiteres mit der eines Smartphones oder ähnlicher Geräte kombinierbar. Auch lässt sich auf diese Weise beispielsweise eine Bedienoberfläche für eine rein als Fingerabdruckaufnahmegerät konzipierte Vorrichtung realisieren. Die Vorrichtung kann auf diese Weise besonders kompakt und bedienfreundlich realisiert werden.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

### Kurze Beschreibung der Zeichnungen

Nachfolgend wird die Erfindung beispielsweise anhand der beigefügten Zeichnungen, die auch erfindungswesentliche Merkmale offenbaren, noch näher erläutert. Es zeigen:
- Fig. 1a,1b,: den grundlegenden Aufbau einer Vorrichtung zur Aufnahme von Abdrücken von durchbluteten Hautbereichen,
- Fig. 2: die optischen Verhältnisse für Licht, welches für die Aufnahme verwendet wird,
- Fig. 3 bis 5: weitere Ausgestaltungen einer solchen Vorrichtung,
- Fig. 6: die Anzeige auf einer Aufnahmevorrichtung für den korrekten Ablauf des Aufnahmeverfahrens,
- Fig. 7 bis 10: den Ablauf des Aufnahmeverfahrens mit Korrekturaufforderungen, und
- Fig. 11: eine Ausgestaltung, bei der mobile Kommunikationsgeräte verwendet werden.

### Ausführliche Beschreibung der Zeichnungen

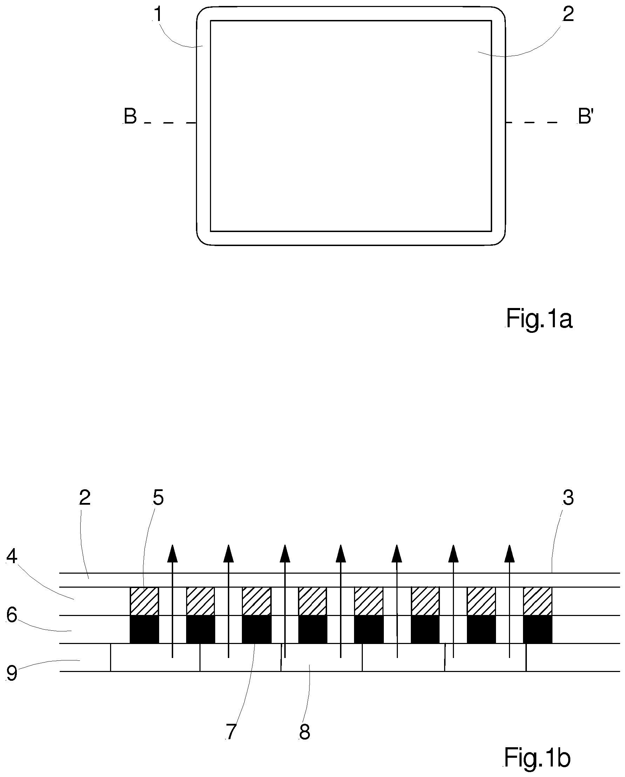

In Fig. 1a ist zunächst das grundlegende Design einer Vorrichtung zur Aufnahme von Abdrücken von durchbluteten Hautbereichen menschlicher Autopodien oder Teilen davon dargestellt.

Fig. 1a zeigt eine Draufsicht auf eine Vorrichtung zur Aufnahme von solchen Abdrücken. Aus dieser Richtung blickt auch ein Betrachter bzw. eine Person, deren Fingerabdrücke genommen werden müssen, auf die Vorrichtung bzw. werden die Hautbereiche, deren Abdrücke genommen werden sollen, aus einem Raumwinkelbereich um die Oberfläche der Vorrichtung dieser angenähert. Aus dieser Richtung sind zunächst nur ein Rahmen 1 und eine Schutzschicht 2 zu erkennen. Die Schutzschicht 2 ist optional und verhindert ein Verschmutzen oder eine Zerstörung der darunter liegenden optischen Komponenten. Die Vorrichtung kann beispielsweise als Smartphone oder als Tablet ausgestaltet sein oder in ein solches integriert sein.

In Fig. 1b ist ein Teil eines Schnittes durch die als Schichtkörper ausgeprägte Vorrichtung entlang einer Linie B-B' in einer Ebene senkrecht zur Blattebene gezeigt. Die Oberseite der Schutzschicht 2 bildet eine Auflagefläche 3. Auf der anderen Seite der Schutzschicht 2, der Auflagefläche 3 abgewandt, ist optional ein als Hochpass ausgebildeter Spektralfilter 4 angeordnet. Die Grenzwellenlänge des Spektralfilters 4 ist dabei in Abhängigkeit von dem optischen Absorptionsverhalten der durchbluteten Hautbereiche vorgegeben, sie liegt vorteilhaft in einem Bereich zwischen 500 und 650 oder zwischen 550 und 600 nm, bevorzugt beispielsweise bei 550 nm, 575 oder 600 nm. Licht mit Wellenlängen oberhalb der Grenzwellenlänge, anders ausgedrückt, Licht mit Frequenzen unterhalb einer der Grenzwellenlänge entsprechenden Grenzfrequenz wird von dem Spektralfilter 4 blockiert. Der Spektralfilter 4 ist hier als Array einzelner Filterelemente 5 ausgebildet.

Der Vorteil bei der Ausbildung des Spektralfilters aus einzelnen Filterelementen 5 besteht darin, dass dann alle Farben des sichtbaren Spektrums für die Anzeige von Informationen durch die Spektralfilterschicht gelangen können und somit für den Benutzer sichtbar sind, wohingegen bei einer durchgehenden Spektralfilterschicht 4 nur Licht der Wellenlängen, für die der Spektralfilter 4 durchlässig ist, für die Darstellung von Informationen genutzt werden kann. Beispielsweise lässt sich dann bei einer Grenzwellenlänge von 550 nm kein rotes Licht mehr für die Darstellung von Informationen verwenden, was für das intuitive Erfassen durch eine die Vorrichtung benutzende Person nachteilig sein kann.

Unterhalb des Spektralfilters 4 ist eine Sensorschicht 6 mit in einem ersten Pixelraster angeordneten lichtempfindlichen Sensorelementen 7 angeordnet. Die Sensorelemente haben vorgegebene laterale Abmessungen, die eine Auflösung von mindestens 500 ppi erlauben. Der Abstand eines jeden Sensorelements 7 zur Auflagefläche 3 beträgt dabei weniger als der Pixelpitch des ersten Pixelrasters. Die Filterelemente 5 sind bei dieser Ausführung genau oberhalb der Sensorelemente 7 platziert, so dass tatsächlich nur Licht registriert wird, dessen Wellenlänge kleiner als die Grenzwellenlänge ist, während für die Darstellung Licht des gesamten optischen Spektrums verwendet werden kann.

Unterhalb der lichtempfindlichen Sensorelemente 7 ist - hier vereinfacht dargestellt - eine Beleuchtungseinrichtung angeordnet. Diese umfasst hier mehrere, nebeneinander angeordnete, aktiv lichtabstrahlende Elemente 8. Diese sind rasterförmig in einem zweiten Pixelraster angeordnet. Das zweite Pixelraster hat hier einen anderen Pixelpitch als das erste Pixelraster. Die aktiv lichtabstrahlenden Elemente 8 strahlen Licht in einem Frequenzbereich ab, für welchen der optionale Spektralfilter 4 und die Sensorschicht 6 zumindest teilweise durchlässig sind, so dass von der Auflagefläche 3 in Richtung eines Hautbereichs abgestrahltes Licht in diesen einkoppelbar ist. Außerdem sind die lichtabstrahlenden Elemente 8 einzeln oder gruppenweise ansteuer- und damit ein- und ausschaltbar. Die Darstellung in Fig.1b und in den folgenden Figuren ist diesbezüglich nicht maßstabsgetreu und dient nur dem besseren Verständnis des Aufbaus. Die lichtabstrahlenden Elemente 8 sind hier in einer gesonderten Beleuchtungsschicht 9 angeordnet und aktiv lichtabstrahlend ausgebildet. Die Abstrahlrichtung wird durch die Pfeile gekennzeichnet. Anstelle aktiv lichtabstrahlender Elemente 8 lassen sich äquivalent auch passiv lichtabstrahlende Elemente mit einer gesonderten Beleuchtungseinrichtung verwenden, beispielsweise LC-Displays mit Hintergrundbeleuchtung, wobei nicht die Hintergrundbeleuchtung ein- bzw. ausgeschaltet wird, sondern die Transmissivität der passiv lichtabstrahlenden Elemente.

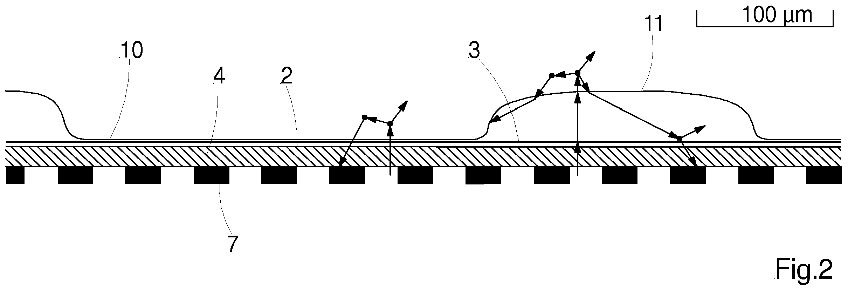

Dem besseren Verständnis der Arbeitsweise der Vorrichtung bzw. eines Verfahrens zur optischen Aufnahme von Abdrücken von durchbluteten Hautbereichen menschlicher Autopodien oder Teilen davon dient Fig. 2. Hier wurde auf die Darstellung einer aktiven oder passiven Beleuchtungseinrichtung, welche selbstverständlich vorhanden ist, der Übersichtlichkeit halber verzichtet. Die Darstellung ist zumindest in lateraler Richtung annähernd maßstabsgetreu. Der Spektralfilter 4 ist hier der Einfachheit halber als durchgehende Schicht ausgebildet. Fig. 2 zeigt die Lichtwege bei der Beleuchtung von Hautbergen 10 - den Papillarleisten von Fingern oder anderen Hautbereichen der Hand - und Hauttälern 11 - den Papillarkörperreihen der Haut. Hautberge 10 liegen direkt auf der Auflagefläche 3 auf, Licht tritt, ohne das Medium Luft zu durchdringen direkt in die Haut ein und wird dort gestreut. Ein großer Teil des gestreuten Lichts wird zurückgeworfen und wieder in Richtung der Auflagefläche ausgekoppelt und durch die Auflagefläche 3 hindurch auf die lichtempfindlichen Sensoren 7 gelenkt. Dort wird die Intensität des Lichts registriert. In der Aufnahme des Fingersoder Handabdrucks erscheinen diese Bereiche der Hautberge 10 als hell.

Zwischen der Sensorschicht 6 und den Hauttälern 11 andererseits muss das Licht einen Weg durch Luft zurücklegen, durch Brechung und Reflexion an mehreren Grenzflächen insbesondere für das vom Hautbereich zurückgestreute Licht sind die Reflexions- und Streuverluste höher, so dass diese Bereiche gegenüber den Hautbergen 10 mit verminderter Helligkeit erscheinen. Auf diese Weise ist eine genaue Erfassung eines Finger- oder Handabdrucks möglich. Die mittels der lichtempfindlichen Sensorelemente bestimmten Intensitätswerte werden einer Bildverarbeitung zugeführt. Mit Hilfe von Bildbearbeitungsalgorithmen, wie sie im Stand der Technik bekannt sind und beispielsweise auch in der EP 2 711 869 A2 benannt sind, werden verschiedene Parameter zur Beschreibung des Fingerabdrucks bestimmt, beispielsweise die Position des Fingers oder der Hand, die Form, der Kontrast und / oder der Anpressdruck des mindestens einen Hautbereichs auf der Auflagefläche. In Abhängigkeit von dem bestimmten Ergebnis werden die lichtabstrahlenden Elemente 8 angesteuert und an- oder ausgeschaltet, wobei dies auch eine Änderung des abgestrahlten Farbwerts und/oder der Helligkeit einschließt. Von den lichtabstrahlenden Elementen 8 werden dann visuelle Information dargestellt, welche auf der Auflagefläche 3 einem Benutzer visualisiert werden. Die Vorrichtung hat also auch, im Gegensatz zu der in der EP 2 711 869 A1 beschriebenen Vorrichtung, die Funktion eines Bildschirms. Die visuellen Informationen können beispielsweise darin bestehen, anzudeuten, in welche Richtung ein falsch positionierter Finger verschoben werden muss, ob mehr oder weniger Anpressdruck ausgeübt werden muss, oder auch ob die Aufnahme zufriedenstellend war. Die Auflagefläche 3 kann auch als optisch arbeitendes Touchpad verwendet werden, in Abhängigkeit von der bestimmten Position des Fingers oder der Hand lassen sich dann auch bestimmte Befehle zur Steuerung von Programmen ausführen, wenn beispielsweise vor Auflage der Finger oder der Hand an vorgegebenen Positionen diverse Auswahlmöglichkeiten zum Programmstart, zur Programmbeendung oder zur Änderung der Optionen eines Programms dargestellt worden waren.

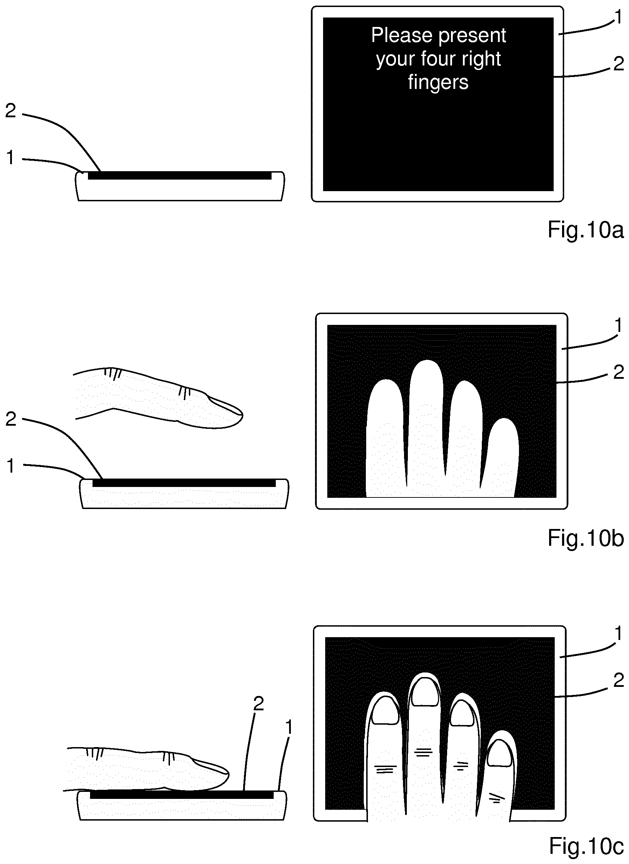

Außerdem lässt sich das Verfahren auch so durchführen, dass Sensorelemente 7 bereits während der Annäherung des Hautbereichs Signale aufnehmen können, diese durch einen Bildbearbeitungsalgorithmus analysiert werden und in dem Fall, dass die Annäherung eines zu registrierenden Hautbereichs verifiziert wird, weitere Schritte initialisiert werden. Diese weiteren Schritte können beispielsweise das Wechseln von Anzeigeelementen, das Aktivieren einer Fingerabdruckaufnahme, das Aktivieren von Audiosignalen oder Ähnliches sein. Ein Beispiel dafür wird in Zusammenhang mit Fig. 10 beschrieben.

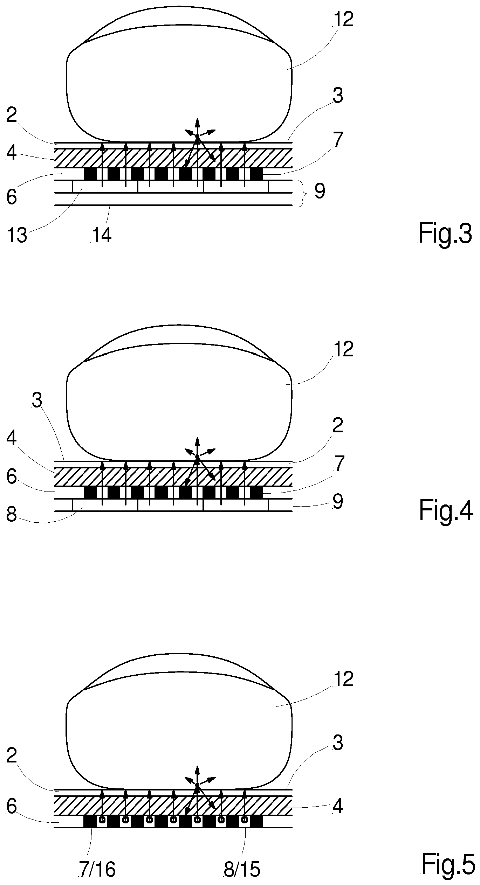

In den Fig. 3-5 sind weitere mögliche Ausgestaltungen einer Vorrichtung zur Aufnahme von Abdrücken von durchbluteten Hautbereichen dargestellt, mit denen sich auch das beschriebene Verfahren realisieren lässt. Der zu untersuchende Hautbereich wird hier durch einen Finger 12 symbolisiert, der Einfachheit halber wird nicht zwischen Hautbergen 10 und Hauttälern 11 unterschieden, da hier nur unterschiedliche Aufbauten gezeigt werden.

Die in den Fig. 3 bis 5 dargestellten Vorrichtungen unterscheiden sich im Wesentlichen nur durch die Art, wie die lichtabstrahlenden Elemente realisiert werden. Der spektrale Filter 4 ist hier jeweils als durchgängige Schicht dargestellt. Allerdings ist laut der beanspruchten Ausführung der Spektralfilter aus einzelnen Filterelementen 5 zusammengesetzt, wie sie bereits im Zusammenhang mit Fig. 1b beschrieben wurden. Bei den in Fig. 2 und Fig. 4 gezeigten Vorrichtungen sind die lichtabstrahlenden Elemente in einer gesonderten Beleuchtungsschicht 9 angeordnet. Bei der in Fig. 3 gezeigten Ausführung sind passiv lichtabstrahlende Elemente 13 vorgesehen, welche über eine Hintergrundbeleuchtung 14 beleuchtet und zwischen den Zuständen "transmissiv" und "opak" umgeschaltet werden können. Auch Zwischenabstufungen sind möglich, dies geschieht durch entsprechende Ansteuerung, beispielsweise indem die Polarisationseigenschaften der transmissiv schaltbaren Elemente variiert werden und die Beleuchtung mit polarisiertem Licht erfolgt. Die Beleuchtungsschicht 9 kann dann beispielsweise ein LC-Display umfassen, welches die passiv lichtabstrahlenden Elemente 13 enthält, mit einer Hintergrundbeleuchtung 14.

Die in Fig. 4 gezeigte Ausführung entspricht im Wesentlichen der in Fig. 1b gezeigten Darstellung, hier sind die lichtabstrahlenden Elemente als aktiv lichtabstrahlende Elemente 8 ausgestaltet, beispielsweise als LED oder OLED. Die lichtabstrahlenden Elemente sind in einer eigenen Beleuchtungsschicht 9 angeordnet.

In anderen Ausführungen könnend die lichtabstrahlenden Elemente, wenn sie als aktiv lichtabstrahlende Elemente 8 ausgestaltet sind, in die Sensorschicht 6 integriert sein. Erstes und zweites Pixelraster liegen dann bevorzugt in einer Ebene, müssen allerdings nicht den gleichen Pixelpitch aufweisen.

Bei der in Fig. 5 gezeigten Ausgestaltung liegen erstes und zweites Pixelraster in einer Ebene, die beiden Pixelraster haben hier identische Pixelpitches, wobei die lichtabstrahlenden Element hier in den Mittelpunkten der Pixel des ersten Pixelrasters und die lichtempfindlichen Sensorelemente in den Mittelpunkten des zweiten Pixelrasters angeordnet sind. Andere Ausgestaltungen sehen einen doppelt so großen Pixelpitch für die lichtabstrahlenden Elemente vor. Als lichtabstrahlende Elemente werden hier beispielsweise LED oder OLED verwendet.

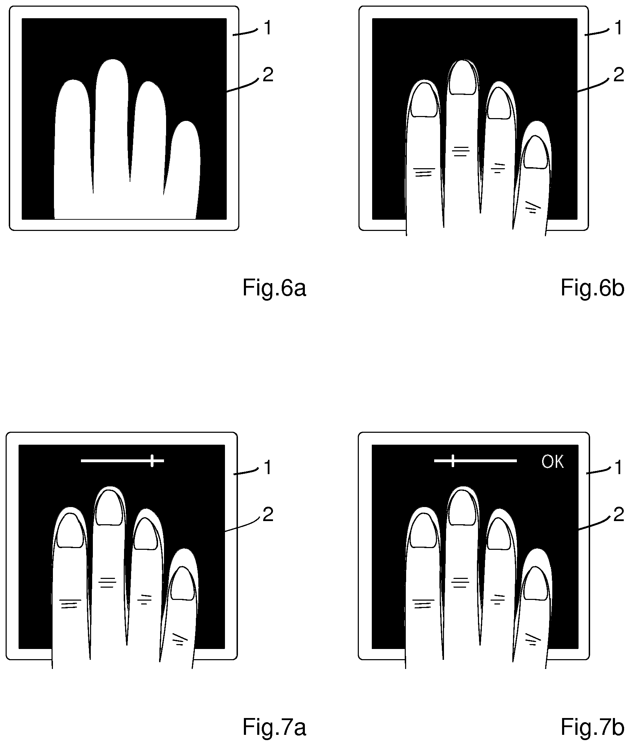

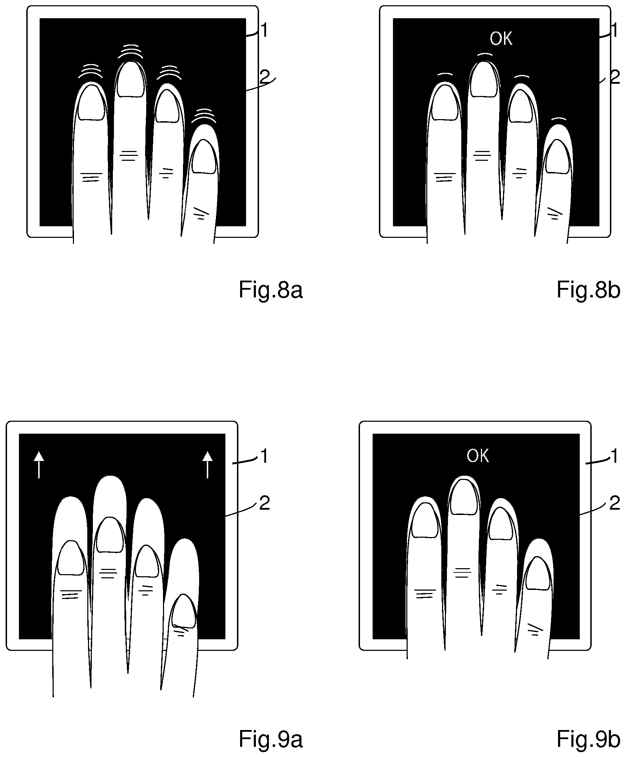

Anhand der Fig. 6 bis 9 wird beispielhaft der Verfahrensablauf und der Umgang mit Fehlern des Benutzers erläutert. Die Vorrichtung wird dabei jeweils durch den Bildschirm, d.h. den Rahmen 1 und die Schutzschicht 2 symbolisiert, welche auch ein Benutzer wahrnimmt. Durch die Möglichkeit der direkten Darstellung von Informationen für den Benutzer auf der Auflagefläche 3 kann der Benutzer - wie in Fig. 6 und Fig. 9 gezeigt - zur optimalen Positionierung und - wie in Fig. 7 und Fig. 8 gezeigt - zur Ausübung eines optimalen Anpressdrucks aufgefordert bzw. angeleitet werden. Sind Position und/oder Anpressdruck der Autopodien entsprechend der Vorgaben eingestellt, d.h. ist die Korrektur durch den Benutzer erfolgt, so kann dies positiv quittiert werden.

Der grundlegende Ablauf des Verfahrens ist in Fig. 6 dargestellt. Fig. 6a zeigt das Gerät im aufnahmebereiten Zustand. Auf der gleichzeitig als Bildschirm dienenden Auflagefläche 3 ist die Silhouette der Autopodien, welche aufgenommen werden sollen, dargestellt. Somit erhält der Benutzer exakte Informationen, wo die Autopodien - hier vier Finger einer Hand - aufgelegt werden sollen. Ebenfalls erhält er die Information, wie sie aufgelegt werden sollen, beispielsweise wird eine Falschauflage in Form von ungewünschter Verdrehung so versucht zu verhindern. In Fig. 6b sind die korrekt auf die vorgesehen Auflagefläche 3 - bzw. die Schutzschicht 2 - aufgelegten Finger des Benutzers zu sehen.

Fig. 7 zeigt eine Ausgestaltung des Verfahrens, bei welchem der Benutzer zur Ausübung eines korrekten Anpressdrucks angeleitet wird. Die beispielhaft als Balken ausgeführte Anzeige im oberen Bereich der Auflagefläche 3 über den Fingern symbolisiert die Höhe des Anpressdrucks, mit dem die Finger die Auflagefläche 3 kontaktieren. In Fig. 7a ist ein Beispiel zu sehen, dass mittels des Balkens signalisiert, dass der Anpressdruck der Finger zu groß ist. Senkt man den Anpressdruck, so wird die Balkenanzeige den geringeren Wert anzeigen. Entspricht der Wert den Vorgaben, wird dies quittiert, wie in Fig. 7b durch den Schriftzug ,OK' dargestellt. Dementsprechend lässt sich auch der Umgang mit zu geringem Anpressdruck behandeln. Zum intuitiveren Verständnis des Benutzers kann die Balkenanzeige auch farbig sein und beispielsweise mit der Farbe "Rot" einen zu hohen, mit der Farbe "Blau" einen zu niedrigen und mit der Farbe "Grün" einen korrekten Anpressdruck anzeigen.

Eine alternative Ausgestaltung des Verfahrens mit der Aufforderung zur Korrektur für zu fest oder zu schwach aufgelegte Finger zeigt Fig. 8. Gegenüber der in Fig. 7 gezeigten Variante besteht hier der Vorteil, dass die Korrekturaufforderung bzw. Druckanzeige individuell für jeden der Finger dargestellt werden kann. Fig. 8a zeigt mehrere - drei - Linien oberhalb der Finger, die einen zu großen Anpressdruck symbolisieren sollen, hier der Einfachheit halber für alle Finger identisch gezeigt. Diese Art der Darstellung lässt aber auch die Anzeige zu, den Benutzer nur zur Korrektur einiger oder gar nur eines speziellen Fingers aufzufordern, indem die darzustellende Information, hier die Anzahl der Linien oberhalb der Finger in Abhängigkeit vom lokalen Anpressdruck des Fingers festgelegt wird. Je mehr Linien oberhalb eines Fingers dargestellt sind, desto höher ist dessen Anpressdruck. Senkt der Benutzer bei dem in Fig. 7a gezeigten Beispiel den Anpressdruck auf das erforderliche Maß, so wird dies über die Anzeige positiv und aktiv quittiert. In Fig. 8b erfolgt eine solche Quittierung über die Darstellung des Wortes "OK" OK'. Alternativ kann die Quittierung auch passiv erfolgen, indem beispielsweise nur die Anzeige der Linien verschwindet. Auch hier können die Linien verschieden Farben haben, um dem Benutzer ein intuitiveres Verständnis zu ermöglichen.

Eine weitere bevorzugte Ausgestaltung des Verfahrens, mit welcher der Benutzer zur korrekten Auflage der Autopodien - hier wieder der Finger - angeleitet wird und so zur Optimierung der Bildaufnahmevoraussetzungen beiträgt, ist in Fig. 9 dargestellt. Legt der Benutzer die Finger nicht richtig positioniert auf, wie in Fig. 9a beispielhaft an zu tief liegenden Fingern dargestellt, so erhält er die Aufforderung zur korrekten Auflage durch die Anzeige von Pfeilen, welche die Richtung symbolisieren, in welche die Finger verschoben werden müssen. Nach erfolgreicher Korrektur der Fingerpositionen erhält der Benutzer ein positives Feedback, in Fig. 9b dargestellt durch die Anzeige des Wortes "OK". Auch hier kann die Anzeige der Pfeile für jeden der Finger individualisiert werden. Außerdem ist eine Kombination mit den Varianten, bei denen Hinweise zur Korrektur des Anpressdrucks gegeben werden, ohne weiteres möglich. Die Hinweise für die Korrektur des Anpressdrucks und für die Korrektur der Fingerposition können gleichzeitig oder nacheinander gezeigt werden. Beispielsweise kann der Benutzer erst in die richtige Position geführt werden, bevor der Anpressdruck korrigiert wird. Sollte der Benutzer bei der Korrektur des Anpressdrucks beispielsweise einen der Finger versehentlich wieder bewegen, so kann dies ebenfalls erneut angezeigt werden, wenn dieser falsch positioniert ist.

In Fig.10a-c ist eine besonders bevorzugte Ausgestaltung des beschriebenen Verfahrens dargestellt, bei dem die lichtempfindlichen Sensorelemente 7 bereits während der Annäherung des Hautbereichs Signale aufnehmen. Die Sensorvorrichtung ist auf der linken Seite jeweils seitlich und auf der rechten Seite von oben dargestellt. In Fig.10a ist die Vorrichtung in einem ersten Zustand, dem Ruhezustand dargestellt. Die Auflagefläche zeigt eine Aufforderung an, bestimmte Hautbereiche - hier als nicht einschränkendes Beispiel die vier rechten Finger - aufzulegen. Nähern sich die Finger, so wird diese Annäherung von der Vorrichtung detektiert und die Vorrichtung schaltet in einen anderen, zweiten Zustand, den Annäherungszustand, welcher in Fig. 10b dargestellt ist. Die Auflagefläche zeigt die Silhouette des aufzunehmenden Hautbereichs. Damit wird die korrekte Positionierung erleichtert. Der Benutzer bekommt somit erstens die Rückmeldung, dass das Gerät auf die Bildaufnahme vorbereitet ist und zweitens erhält er konkrete Information wie und wo er seine Finger aufzulegen hat. Mit dem Kontakt der Auflagefläche schaltet die Anordnung wiederum in einen neuen, dritten Zustand, den Aufnahmezustand, welcher in Fig.10c gezeigt ist. Die Aufnahmeprozedur wird gestartet, die Vorrichtung ist bereit zur Bildaufnahme. Zur Aufnahmeprozedur zählen insbesondere anfängliche Überprüfungen, wie beispielsweise, ob die Finger korrekt positioniert sind und/oder ob der Anpressdruck innerhalb eines vorgegebenen Toleranzbereichs liegt. Diese Überprüfungen und die ggf. damit einhergehenden Anleitungen zur Korrektur der Positionierung und/oder des Anpressdrucks wurden bereits eingehend im Zusammenhang mit den Fig. 7 bis 9 beschrieben.

Der Vorgang des Umschaltens zwischen den drei Zuständen erfolgt in Abhängigkeit vom Ergebnis der Auswertung von Bilddaten, welche die lichtempfindlichen Sensorelemente 7 registrieren, die Aufforderungen und Informationen für den Benutzer erfolgen durch Darstellung durch die Auflagefläche 3 bzw. durch diese hindurch. Die Auflagefläche 3 ist dabei typischerweise die der Sensorschicht 6 abgewandte Seite der durch die Schutzfolie 2 gebildeten Schutzschicht.

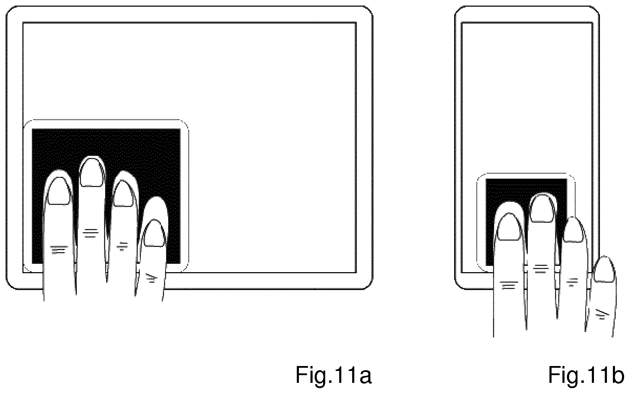

Fig. 11 a-b schließlich zeigt Vorrichtungen, bei denen die lichtabstrahlenenden Elemente durch mobile Kommunikationsgeräte, hier durch einen Tablet-Computer - Fig. 11a - und durch ein Smartphone - Fig. 11b - realisiert werden. Die Sensorschicht 6 wird dabei flächig oberhalb der Beleuchtungsschicht platziert. Das mobile Kommunikationsgerät dient also gleichzeitig der Beleuchtung, der Anzeige visuelle, haptischer und/oder akustischer Informationen sowie optional zur Steuerung der Sensorschicht. Die Sensorschicht kann dauerhaft mit dem mobilen Kommunikationsgerät, oder aber lösbar mit diesem verbunden sein. Auf diese Weise werden sehr flache und mobile Vorrichtungen realisiert.

Mit dem vorangehend beschriebenen Verfahren und den zugehörigen Vorrichtungen ist zum einen ein besonders kompakter Aufbau eines Fingerabdrucksensors möglich, der darüber hinaus vielseitig einsetzbar und portabel ist, und einem Benutzer intuitiv zu verstehende Hinweise zur Verwendung bzw. zur Korrektur der Positionierung der Hautbereiche, deren Abdrücke aufgenommen werden sollen, geben kann.

### Bezugszeichenliste

- 1: Rahmen
- 2: Schutzschicht
- 3: Auflagefläche
- 4: Spektralfilter
- 5: Filterelement
- 6: Sensorschicht
- 7: lichtempfindliches Sensorelement
- 8: aktiv lichtabstrahlendes Element
- 9: Beleuchtungsschicht
- 10: Hautberg
- 11: Hauttal
- 12: Finger
- 13: passiv lichtabstrahlendes Element
- 14: Hintergrundbeleuchtung
- 15: bidirektionale LED
- 16: opakes Element

## Patentansprüche

1. Verfahren zur optischen Aufnahme von Abdrücken von durchbluteten Hautbereichen mehrerer menschlicher Autopodien oder Teilen davon, bei dem
- mindestens ein Hautbereich, dessen Abdruck genommen werden soll, einer Auflagefläche (3) einer Vorrichtung zur Aufnahme solcher Abdrücke genähert und auf diese aufgelegt wird,
- mehrere, rasterförmig in einem zweiten Pixelraster angeordnete, einzeln oder gruppenweise ansteuerbare, lichtabstrahlende Elemente (8, 13) zur Beleuchtung des mindestens einen Hautbereichs an- oder abgeschaltet werden,
- das von den lichtabstrahlenden Elementen (8, 13) abgestrahlte Licht durch einen Schichtkörper, enthaltend eine Sensorschicht (6) mit in einem ersten Pixelraster angeordneten, lichtempfindlichen Sensorelementen (7) vorgegebener lateraler Abmessungen, einen Spektralfilter (4) und durch die Auflagefläche (3) hindurch auf und in den mindestens einen Hautbereich gelenkt wird, wo das Licht je nach Beschaffenheit und Lage des Hautbereichs umgelenkt und ggf. wieder in Richtung der Auflagefläche (3) ausgekoppelt wird, durch die Auflagefläche (3) und den Spektralfilter (4) hindurch auf die lichtempfindlichen Sensorelemente (7) gelenkt und dort die Intensität des Lichts registriert wird,
- wobei der Spektralfilter (4) als Hochpass mit einer in Abhängigkeit von dem optischen Absorptionsverhalten der durchbluteten Hautbereiche vorgegebenen Grenzwellenlänge ausgebildet und für von den lichtabstrahlenden Elementen (8, 13) abgestrahltes Licht zumindest teilweise durchlässig ist und
- Filterelemente (5) aufweist, wobei jedes einzelne Filterelement (5) genau oberhalb eines entsprechenden lichtempfindlichen Sensorelements (7) platziert ist,
- wobei der Abstand eines jeden lichtempfindlichen Sensorelements (7) zur Auflagefläche (3) weniger als der Pixelpitch des ersten Pixelrasters beträgt,
- aus durch die lichtempfindlichen Sensorelemente (7) bestimmten Intensitätswerten über Bildverarbeitungsalgorithmen als Ergebnis mindestens die Position, die Form und/oder den Anpressdruck des mindestens einen Hautbereichs auf der Auflagefläche (3) bestimmt wird,
- in Abhängigkeit von dem bestimmten Ergebnis die lichtabstrahlenden Elemente (8, 13) angesteuert und an- oder ausgeschaltet oder ihre Farbwerte und/oder Helligkeit geändert werden, und von den lichtabstrahlenden Elementen (8, 13) visuelle Informationen dargestellt werden, welche auf der Auflagefläche angezeigt werden.

2. Verfahren nach Anspruch 1, **dadurch gekennzeichnet, dass** in Abhängigkeit von der bestimmten Position Programmbefehle ausgeführt werden.

3. Verfahren nach Anspruch 1, **dadurch gekennzeichnet, dass** in Abhängigkeit von dem bestimmten Ergebnis angezeigt oder spürbar gemacht wird, ob eine Veränderung der Position und/oder des Anpressdrucks des Hautbereichs erforderlich ist.

4. Verfahren nach einem der Ansprüche 1 bis 3, **dadurch gekennzeichnet, dass** die lichtempfindlichen Elemente (8, 13) bereits während der Annäherung des Hautbereichs Signale aufnehmen, diese durch einen Bildverarbeitungsalgorithmus analysiert werden, und in dem Fall, dass die Annäherung eines zu registrierenden Hautbereichs verifiziert wird, weitere Schritte initialisiert werden.

5. Verfahren nach Anspruch 4, **dadurch gekennzeichnet, dass** bei der Annäherung des Hautbereichs, unter definierter Beleuchtungsfarbe, aufgenommene spektrale Signale mit bei aufgelegtem Hautbereich, unter definierter Beleuchtungsfarbe, aufgenommenen spektralen Signalen zur Entdeckung von Fälschungen verglichen werden, und vorzugsweise nach der ersten Aufnahme mit definierter Beleuchtungsfarbe Aufnahmen mit weiteren Beleuchtungsfarben folgen.

6. Vorrichtung zur Durchführung eines Verfahrens nach einem der Ansprüche 1 bis 5, zur optischen Aufnahme von Abdrücken von durchbluteten Hautbereichen mehrerer menschlicher Autopodien oder Teilen davon, umfassend aus der Richtung eines aufzulegenden Hautbereichs gesehen,
- eine Auflagefläche (3) zur Auflage mindestens eines Hautbereichs,
- einen Schichtkörper, enthaltend eine Sensorschicht (6) mit in einem ersten Pixelraster angeordneten lichtempfindlichen Sensorelementen (7) vorgegebener lateraler Abmessungen, und
- mehrere, nebeneinander angeordnete, lichtabstrahlende Elemente (8, 13), **dadurch gekennzeichnet, dass**
- die lichtabstrahlenden Elemente (8, 13) (i) rasterförmig in einem zweiten Pixelraster angeordnet sind, (ii) Licht in einem Frequenzbereich abstrahlend ausgebildet sind, für welchen der Schichtkörper mit der Sensorschicht (6) zumindest teilweise durchlässig ist, so dass von der Auflagefläche (3) in Richtung eines Hautbereichs abgestrahltes Licht in diesen einkoppelbar ist, und (iii) zur Darstellung visueller Informationen einzeln oder gruppenweise ansteuer- und damit ein- und ausschaltbar und in dem abgestrahlten Farbwert und/oder der Helligkeit änderbar sind, und
- dass sich zwischen der Auflagefläche (3) und der Sensorschicht (6) ein als Hochpass ausgebildeter Spektralfilter (4) mit einer in Abhängigkeit von dem optischen Absorptionsverhalten der durchbluteten Hautbereiche vorgegebenen Grenzwellenlänge angeordnet ist, der für von den lichtabstrahlenden Elementen (8, 13) abgestrahltes Licht zumindest teilweise durchlässig ist, wobeider Spektralfilter (4) Filterelemente (5) aufweist, welche genau oberhalb der lichtempfindlichen Sensorelemente (7) platziert sind und
- der Abstand eines jeden lichtempfindlichen Sensorelements (7) zur Auflagefläche (3) weniger als der Pixelpitch des ersten Pixelrasters beträgt.

7. Vorrichtung nach Anspruch 6, **dadurch gekennzeichnet, dass** die lichtabstrahlenden Elemente (8, 13) in einer gesonderten Beleuchtungsschicht (9) angeordnet sind.

8. Vorrichtung nach Anspruch 7, **dadurch gekennzeichnet, dass** die lichtabstrahlenden Elemente als passiv Licht abstrahlende Elemente (13) ausgebildet sind.

9. Vorrichtung nach Anspruch 7 oder 8, **dadurch gekennzeichnet, dass** die lichtabstrahlenden Elemente durch das Display eines mobilen Kommunikationsgeräts ausgebildet sind.

10. Vorrichtung nach Anspruch 8, **dadurch gekennzeichnet, dass** die Beleuchtungsschicht (9) ein LC-Display mit einer Hintergrundbeleuchtung (14) umfasst.

11. Vorrichtung nach Anspruch 7, **dadurch gekennzeichnet, dass** die lichtabstrahlenden Elemente als aktiv Licht abstrahlende Elemente (8), bevorzugt als LED oder OLED, ausgebildet sind.

12. Vorrichtung nach Anspruch 6, **dadurch gekennzeichnet, dass** die lichtabstrahlenden Elemente (8, 13) in die Sensorschicht (6) integriert sind, wobei erstes und zweites Pixelraster bevorzugt in einer Ebene liegen, und/oder die lichtabstrahlenden Elemente als aktiv Licht abstrahlende Elemente (8), bevorzugt als LED oder OLED, ausgestaltet sind.

13. Vorrichtung nach Anspruch 12, **dadurch gekennzeichnet, dass** erstes und zweites Pixelraster identische Pixelpitches haben, die lichtabstrahlenden Elemente (8, 13) in den Mittelpunkten der Pixel des ersten Pixelrasters und die lichtempfindlichen Sensorelemente (7) in den Mittelpunkten des zweiten Pixelrasters angeordnet sind.

## Claims

1. A method for optically recording impressions of areas of skin, through which blood flows, of a plurality of human autopods or parts thereof, wherein
- at least one area of skin, of which an impression is to be taken, is approached to and placed on a placement surface (3) of a device for taking such impressions,
- a plurality of light-emitting elements (8, 13), which are arranged in a grid-like manner in a second pixel grid and can be controlled individually or in groups, are switched on or off for illuminating the at least one area of skin,
- the light emitted by the light-emitting elements (8, 13) is directed through a layered body containing a sensor layer (6) with light-sensitive sensor elements (7) of predetermined lateral dimensions arranged in a first pixel grid, a spectral filter (4) and through the placement surface (3) onto and into the at least one area of skin, where the light is deflected depending on the nature and position of the area of skin and, if necessary, is coupled out again in the direction of the placement surface (3), is directed through the placement surface (3) and the spectral filter (4) onto the light-sensitive sensor elements (7) and there the intensity of the light is registered,
- wherein the spectral filter (4) is configured as a high-pass filter with a cut-off wavelength predetermined as a function of the optical absorption behaviour of the areas of skin through which blood flows and being at least partially transparent to light emitted by the light-emitting elements (8, 13), and
- has filter elements (5), each individual filter element (5) being placed exactly above a corresponding light-sensitive sensor element (7),
- wherein the distance of each light-sensitive sensor element (7) from the placement surface (3) is less than the pixel pitch of the first pixel grid,
- from intensity values determined by the light-sensitive sensor elements (7), at least the position, shape and/or contact pressure of the at least one area of skin on the placement surface (3) is determined as a result via image processing algorithms,
- depending on the determined result, the light-emitting elements (8, 13) are controlled and switched on or off or their colour values and/or brightness are changed, and visual information is displayed by the light-emitting elements (8, 13) which is displayed on the placement surface.

2. The method according to claim 1, **characterised in that** program commands are executed as a function of the determined position.

3. The method according to claim 1, **characterised in that**, depending on the determined result, it is indicated or made perceptible whether a change in the position and/or the contact pressure of the area of skin is required.

4. The method according to any one of claims 1 to 3, **characterised in that** the light-sensitive elements (8, 13) already record signals during the approach of the area of skin, which signal are analyzed by an image processing algorithm, and in the case that the approach of a area of skin to be registered is verified, further steps are initialized.

5. The method according to claim 4, **characterised in that** spectral signals recorded during the approach of the area of skin, having a defined illumination colour, are compared with spectral signals recorded with the area of skin in place, having a defined illumination colour, for the detection of falsifications, and preferably after the first recording with a defined illumination colour, recordings with further illumination colours follow.

6. A device for carrying out a method according to any one of claims 1 to 5, for optically recording impressions of areas of skin, through which blood flows, of a plurality of human autopods or parts thereof, comprising as viewed from the direction of an area of skin to be placed thereon:
- a placement surface (3) for placing at least one area of skin thereon,
- a layered body containing a sensor layer (6) with light-sensitive sensor elements (7) of predetermined lateral dimensions arranged in a first pixel grid, and
- a plurality of light-emitting elements (8, 13) arranged side by side, **characterised in that**
- the light-emitting elements (8, 13) (i) are arranged in the form of a grid in a second pixel grid, (ii) are configured to emit light in a frequency range for which the layered body with the sensor layer (6) is at least partially transparent, so that light emitted from the placement surface (3) in the direction of a area of skin can be coupled into the latter, and (iii) in order to display visual information, can be controlled individually or in groups for and can thus be switched on and off, allowing to change the emitted colour value and/or brightness, and
- **in that** a spectral filter (4) in the form of a high-pass filter with a cut-off wavelength which is predetermined as a function of the optical absorption behaviour of the areas of skin through which blood flows is arranged between the placement surface (3) and the sensor layer (6) and is at least partially transparent to light emitted by the light-emitting elements (8, 13), wherein the spectral filter (4) has filter elements (5) which are placed exactly above the light-sensitive sensor elements (7) and
- the distance of each light-sensitive sensor element (7) from the placement surface (3) is less than the pixel pitch of the first pixel grid.

7. The device according to claim 6, **characterised in that** the light-emitting elements (8, 13) are arranged in a separate illumination layer (9).

8. The device according to claim 7, **characterised in that** the light-emitting elements are formed as passive light-emitting elements (13).

9. The device according to claim 7 or 8, **characterised in that** the light-emitting elements are formed by the display of a mobile communication device.

10. The device according to claim 8, **characterised in that** the illumination layer (9) comprises an LC display with a backlight (14).

11. The device according to claim 7, **characterised in that** the light-emitting elements are configured as active light-emitting elements (8), preferably as LEDs or OLEDs.

12. The device according to claim 6, **characterised in that** the light-emitting elements (8, 13) are integrated into the sensor layer (6), with the first and second pixel grids preferably lying in one plane, and/or the light-emitting elements are configured as active light-emitting elements (8), preferably as LEDs or OLEDs.

13. The device according to claim 12, **characterised in that** the first and second pixel grids have identical pixel pitches, the light emitting elements (8, 13) are arranged at the centres of the pixels of the first pixel grid, and the light-sensitive sensor elements (7) are arranged at the centres of the second pixel grid.

## Revendications

1. Procédé de réception optique d'empreintes de zones de peau irriguées de plusieurs autopodes humains ou de parties de ceux-ci, dans lequel
- au moins une zone de peau dont l'empreinte doit être prise est approchée d'une surface d'appui (3) d'un dispositif destiné à recevoir de telles empreintes et est posée sur celle-ci,
- plusieurs éléments émetteurs de lumière (8, 13), disposés en forme de trame dans une deuxième trame de pixels et pouvant être commandés individuellement ou par groupes, sont activés ou désactivés pour éclairer ladite au moins une zone de peau,
- la lumière émise par les éléments émetteurs de lumière (8, 13) est déviée à travers un corps stratifié, contenant une couche de capteur (6) avec des éléments de capteur photosensibles (7) de dimensions latérales prédéfinies, disposés dans une première trame de pixels, un filtre spectral (4), et à travers la surface d'appui (3), sur et dans ladite au moins une zone de peau, où la lumière est déviée en fonction de la nature et de la position de la zone de peau et, le cas échéant, est à nouveau découplée en direction de la surface d'appui (3), est dirigée à travers la surface d'appui (3) et le filtre spectral (4) sur les éléments de capteur photosensibles (7) et l'intensité de la lumière y est enregistrée,
- le filtre spectral (4) étant réalisé sous la forme d'un filtre passe-haut avec une longueur d'onde limite prédéfinie en fonction du comportement d'absorption optique des zones de peau irriguées et étant au moins partiellement perméable à la lumière émise par les éléments émetteurs de lumière (8, 13) et
- comprenant des éléments de filtre (5), chaque élément de filtre individuel (5) étant placé exactement au-dessus d'un élément de capteur photosensible (7) correspondant,
- la distance de chaque élément de capteur photosensible (7) par rapport à la surface d'appui (3) étant inférieure au pas de pixel de la première trame de pixels,
- à partir de valeurs d'intensité déterminées par les éléments de capteur photosensibles (7), on détermine comme résultat, par l'intermédiaire d'algorithmes de traitement d'images, au moins la position, la forme et/ou la pression d'appui de ladite au moins une zone de peau sur la surface d'appui (3),
- en fonction du résultat déterminé, les éléments émetteurs de lumière (8, 13) sont commandés et activés ou désactivés ou leurs valeurs de couleur et/ou leur luminosité sont modifiées, et des informations visuelles sont représentées par les éléments émetteurs de lumière (8, 13), lesquelles sont affichées sur la surface d'appui.

2. Procédé selon la revendication 1, **caractérisé en ce que** des instructions de programme sont exécutées en fonction de la position déterminée.

3. Procédé selon la revendication 1, **caractérisé en ce que**, en fonction du résultat déterminé, il est indiqué ou rendu perceptible si une modification de la position et/ou de la pression d'application de la zone de peau est nécessaire.

4. Procédé selon l'une quelconque des revendications 1 à 3, **caractérisé en ce que** les éléments photosensibles (8, 13) reçoivent des signaux dès l'approche de la zone de peau, ceux-ci sont analysés par un algorithme de traitement d'image, et dans le cas où l'approche d'une zone de peau à enregistrer est vérifiée, d'autres étapes sont initialisées.

5. Procédé selon la revendication 4, **caractérisé en ce que** des signaux spectraux enregistrés lors de l'approche de la zone de peau, avec une couleur d'éclairage définie, sont comparés à des signaux spectraux enregistrés lorsque la zone de peau est en appui, avec une couleur d'éclairage définie, pour la détection de falsifications, et de préférence des enregistrements avec d'autres couleurs d'éclairage suivent le premier enregistrement avec une couleur d'éclairage définie.

6. Dispositif pour la mise en oeuvre d'un procédé selon l'une quelconque des revendications 1 à 5, pour l'enregistrement optique d'empreintes de zones de peau irriguées de plusieurs autopodes humains ou de parties de ceux-ci, ledit dispositif comprenant, vu depuis la direction d'une zone de peau à appuyer:
- une surface d'appui (3) pour l'appui d'au moins une zone de peau,
- un corps stratifié, contenant une couche de capteur (6) avec des éléments de capteur photosensibles (7), disposés dans une première trame de pixels, de dimensions latérales prédéfinies, et
- plusieurs éléments émetteurs de lumière (8, 13), disposés les uns à côté des autres, **caractérisé en ce que**
- les éléments émetteurs de lumière (8, 13) (i) sont disposés en forme de trame dans une deuxième trame de pixels, (ii) sont réalisés de manière à émettre de la lumière dans une plage de fréquences pour laquelle le corps stratifié avec la couche de capteur (6) est au moins partiellement perméable, de sorte que de la lumière émise par la surface d'appui (3) en direction d'une zone de peau peut être couplée dans celle-ci, et (iii) peuvent être commandés individuellement ou par groupes pour la représentation d'informations visuelles et peuvent ainsi être activés et désactivés et être modifiés en ce qui concerne la valeur de couleur émise et/ou la luminosité, et
- **en ce qu'**entre la surface d'appui (3) et la couche de capteur (6) est disposé un filtre spectral (4) conçu comme un filtre passe-haut avec une longueur d'onde limite prédéfinie en fonction du comportement d'absorption optique des zones de peau irriguées, qui est au moins partiellement perméable pour la lumière émise par les éléments émetteurs de lumière (8, 13), le filtre spectral (4) présentant des éléments de filtre (5) qui sont placés exactement au-dessus des éléments de capteur photosensibles (7) et
- la distance de chaque élément de capteur photosensible (7) par rapport à la surface d'appui (3) est inférieure au pas de pixel de la première trame de pixels.

7. Dispositif selon la revendication 6, **caractérisé en ce que** les éléments émetteurs de lumière (8, 13) sont disposés dans une couche d'éclairage séparée (9).

8. Dispositif selon la revendication 7, **caractérisé en ce que** les éléments émetteurs de lumière sont conçus comme des éléments émetteurs de lumière passifs (13).

9. Dispositif selon la revendication 7 ou 8, **caractérisé en ce que** les éléments émetteurs de lumière sont formés par l'écran d'un appareil de communication mobile.

10. Dispositif selon la revendication 8, **caractérisé en ce que** la couche d'éclairage (9) comprend un écran à cristaux liquides avec un éclairage de fond (14).

11. Dispositif selon la revendication 7, **caractérisé en ce que** les éléments émetteurs de lumière sont conçus comme des éléments émetteurs de lumière actifs (8), de préférence comme des LED ou des OLED.

12. Dispositif selon la revendication 6, **caractérisé en ce que** les éléments émetteurs de lumière (8, 13) sont intégrés dans la couche de capteur (6), la première et la deuxième trame de pixels étant de préférence dans un seul plan, et/ou les éléments émetteurs de lumière sont conçus comme des éléments émetteurs de lumière actifs (8), de préférence comme des LED ou des OLED.

13. Dispositif selon la revendication 12, **caractérisé en ce que** la première et la deuxième trame de pixels ont des pas de pixels identiques, les éléments émetteurs de lumière (8, 13) sont disposés aux points centraux des pixels de la première trame de pixels et les éléments de capteur photosensibles (7) sont disposés aux points centraux de la deuxième trame de pixels.
